# EUROPEAN PATENT SPECIFICATION

(11) **EP 3 607 415 B1**
(45) Date of publication and mention of the grant of the patent: **11.11.2026**
(21) Application number: 18781356.3
(22) Date of filing: 02.03.2018
(51) Int. Cl.: G11C 29/50, G11C 29/06, G11C 29/12, G11C 29/24, G11C 29/46, G11C 11/413, G11C 11/419, G06F 1/3234, G11C 5/14, G11C 7/22, G11C 29/04

(54) **ADAPTIVE VOLTAGE SYSTEM FOR AGING GUARD-BAND REDUCTION**
ADAPTIVES SPANNUNGSSYSTEM ZUR REDUZIERUNG DES ALTERUNGSSCHUTZBANDES
SYSTÈME DE TENSION ADAPTATIVE DESTINÉ À RÉDUIRE LE VIEILLISSEMENT D'UNE BANDE DE GARDE

(30) Priority: 03.04.2017 US 201715477913
(43) Date of publication of application: 12.02.2020
(73) Proprietor: Intel Corporation, Santa Clara, CA 95054 (US)
(72) Inventor: CHO, Minki, Portland, Oregon 97229 (US); KULKARNI, Jaydeep, Austin, Texas 78723 (US); TOKUNAGA, Carlos, Hillsboro, Oregon 97124 (US); KHELLAH, Muhammad, Tigard, Oregon 97224 (US); TSCHANZ, James, Portland, Oregon 97229 (US)
(74) Representative: HGF
(86) International application number: PCT/US2018/020607
(87) International publication number: WO 2018/186957

(56) References cited:
- EP-A2- 2 610 873
- US-A1- 2011 013 470
- US-A1- 2013 003 442
- US-A1- 2013 328 117
- US-A1- 2014 022 008
- US-A1- 2014 036 609
- US-A1- 2014 040 692
- US-A1- 2014 071 735
- US-A1- 2014 223 205
- US-A1- 2015 235 696
- US-A1- 2015 279 438
- V.HUARD ET AL.: "Aging-aware adaptive voltage scaling of product blocks in 28nm nodes", RELIABILITY PHYSICS SYMPOSIUM (IRPS), 2016 IEEE INTERNATIONAL, 17 April 2016 (2016-04-17), XP032969794

## Description

### CLAIM FOR PRIORITY

This application claims priority to U.S. Patent Application Serial No. 15/477,913, filed on April 3, 2017, titled "ADAPTIVE VOLTAGE SYSTEM FOR AGING GUARD-BAND REDUCTION,".

### BACKGROUND

In advanced process technology nodes, process (P), voltage (V), and temperature (T) variations (also referred to as "PVT" variations), and aging behavior can degrade performance and reliability of a design. To mitigate these issues, modern microprocessor and/or system-on-chip (SoC) designs add fixed voltage/timing margin guardband or margin to guarantee target performance and reliability of the microprocessor or SoC. Moreover, these PVT variations and aging may be infrequent in nature. Hence, adding guardband or margin to avoid variation-caused errors hurts energy efficiency and performance.
US20140036609 relates to a method for testing the retention mode of an array of SRAM cells. US20140071735 relates to a method for writing concurrently a binary logical value to one or more dummy memory cells in a dummy bit line pair.
US20110013470 relates to an integrated circuit containing an SRAM that provides a switch to decouple the SRAM wordline voltage from the SRAM array voltage during screening.
EP2610873 relates to prevention of yield loss resulting from peripheral circuit failure while screening memory arrays for aging effects by performing memory read and write margin testing at a minimum operating voltage.
US20150279438 relates to an assist circuit that may be coupled to one or more components of a memory system to selectively lower a supply voltage that is delivered to the component.
US20140040692 relates to identifying potential errors that might result from operating logic and/or memory circuits at an insufficient operating voltage by electrically altering nodes of replica or operational circuits so that the electrically altered nodes are susceptible to errors.
US20130003442 relates to a memory bank including memory cells and an additional cell to determine an operating voltage of the memory bank.

### SUMMARY

The invention is defined in independent claim 1. Further preferred embodiments are defined in the dependent claims. Only embodiments of the description comprising all the technical features of the claims fall under the scope of protection of the claims while the remaining ones correspond to illustrative examples which are useful for the understanding of the relevant technical context.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
Fig. 1 illustrates a high level architecture of an adaptive voltage system, according to some embodiments of the disclosure.
Fig. 2 illustrates a high level architecture of an adaptive voltage system with Retention Vmin Monitor (RVM) for a memory array, according to some embodiments of the disclosure.
Figs. 3A-F illustrate RVM circuitries, according to some embodiments of the disclosure.
Figs. 4A-B illustrate plots showing static noise margin (SNM) before and after aging, respectively.
Fig. 5A illustrates a plot showing Vmin for a memory array across process variation and aging with and without RVM circuitries, according to some embodiments.
**Fig. 5B** illustrates a plot showing Vmin with aging period for a memory bit-cell and a two stack diode-connected RVM, according to some embodiments.
**Fig. 6** illustrates a plot with waveforms showing sampling and stress timing diagram, according to some embodiments of the disclosure.
**Figs. 7A-B** illustrate plots showing power savings using the RVM circuitries of some embodiments.
**Fig. 8** illustrates a smart device or a computer system or a SoC (System-on-Chip) with the adaptive voltage system, according to some embodiments.

### DETAILED DESCRIPTION

Since aging effect on transistors occurs differently depending on usage and conditions by a user of an integrated circuit (IC or chip), large fixed aging guardband or margin may end up being added to even a less-aged chip (or IC), which in turn increases power consumption during the lifetime of the chip. Transistor or device aging occurs in both memory array and logic of an IC, which increases the threshold voltage of devices resulting in higher propagation delays and higher active Vmin. Here, the term "Vmin" generally refers to a minimum operating supply voltage below which the logic or memory does not function properly. For example, Vmin for a memory is the minimum supply voltage below which a memory bit-cell may lose its data or is unable to write data to it. Increasing the supply voltage to an IC or chip, however, will increase the speed of the chip's aging transistors. As such, a larger Vmin is specified for the semiconductor chip so that a sufficient amount of supply voltage is provided to the chip's transistors over the course of the chip's lifetime that permit the chip to operate at least a minimum specified clock speed for its entire life.

Additionally, in the case of a memory circuit (e.g., a static random access memory (SRAM), as the transistors of a memory cell age, the memory cell needs to be supplied with a larger supply voltage in order to prevent the memory cell from losing its stored data. As such, a larger Vmin is specified for the semiconductor chip so that a sufficient supply voltage is applied to the memory circuit's memory cells so that they retain their data over the course of the semiconductor chip's lifetime.

Thus, the specified Vmin for a semiconductor chip is set at an artificially high power supply level over the earlier timeframe of the chip's operational lifetime. In the early stages of the chip's lifetime, the semiconductor chip's transistors are not substantially aged. As such, they could operate at a lower supply voltage. However, the minimum supply voltage is established to a higher voltage level to ensure that the transistors will receive sufficient supply voltage when they eventually age later on in the semiconductor chip's lifetime. The artificially high supply voltage that is supplied to the semiconductor chip early in its life, corresponds to inefficiency in that the semiconductor chip. This inefficiency consumes more power with the artificially high supply voltage than it otherwise needs to. Memory arrays (e.g., rows and columns of SRAM bit-cells), in the semiconductor chip, with very low activation probability are in retention mode (e.g., low power mode, standby mode, sleep mode, etc.) for the majority of the time. Hence, retention Vmin reduction/monitor are used for mitigating the aging-induced degradation.

Some embodiments describe an adaptive voltage system (AVS) using tunable replica circuits (TRC) as logic aging monitor, tunable replica bit (TRB) circuitry for memory array, and bit-cell retention Vmin monitor (RVM) circuit as memory array aging monitor. In some embodiments, the TRC detects timing margin and error in advance, and provides an output to a power management unit (PMU). In some embodiments, the TRB circuitry provides a timing margin for a memory array. While the TRC tracks the Vmin of a logic block and the TRB circuitry tracks the timing margin for a memory array, the TRC and TRB circuitries may not track a memory bit-cell retention Vmin.

Some embodiments describe a RVM circuitry for memory arrays to track the bit-cell aging across operational modes (e.g., normal mode or active mode, and low power mode or sleep mode). In some embodiments, the RVM circuitry provides an output to the PMU. In some embodiments, the PMU modulates the power supply voltage (e.g., generated by a voltage regulator, a low dropout (LDO) circuitry, a DC-DC converter, etc.) for the memory array and the logic to avoid any logic/memory failure due to aging induced degradation.

In the following description, numerous details are discussed to provide a more thorough explanation of embodiments of the present disclosure. It will be apparent, however, to one skilled in the art, that embodiments of the present disclosure may be practiced without these specific details. In other instances, well-known structures and devices are shown in block diagram form, rather than in detail, in order to avoid obscuring embodiments of the present disclosure.

Note that in the corresponding drawings of the embodiments, signals are represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, as dictated by design needs or preferences, may actually comprise one or more signals that may travel in either direction and may be implemented with any suitable type of signal scheme.

Throughout the specification, and in the claims, the term "connected" means a direct connection, such as electrical, mechanical, or magnetic connection between the things that are connected, without any intermediary devices. The term "coupled" means a direct or indirect connection, such as a direct electrical, mechanical, or magnetic connection between the things that are connected or an indirect connection, through one or more passive or active intermediary devices. The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The terms "substantially," "close," "approximately," "near," and "about," generally refer to being within +/- 10% of a target value (unless specifically specified). Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

For purposes of the embodiments, the transistors in various circuits and logic blocks described here are metal oxide semiconductor (MOS) transistors or their derivatives, where the MOS transistors include drain, source, gate, and bulk terminals. The transistors and/or the MOS transistor derivatives also include Tri-Gate and FinFET transistors, Gate All Around Cylindrical Transistors, Tunneling FET (TFET), Square Wire, or Rectangular Ribbon Transistors, ferroelectric FET (FeFETs), or other devices implementing transistor functionality like carbon nanotubes or spintronic devices. MOSFET symmetrical source and drain terminals i.e., are identical terminals and are interchangeably used here. A TFET device, on the other hand, has asymmetric Source and Drain terminals. Those skilled in the art will appreciate that other transistors, for example, Bi-polar junction transistors-BJT PNP/NPN, BiCMOS, CMOS, eFET, etc., may be used without departing from the scope of the disclosure. The term "MN" indicates an n-type transistor (e.g., NMOS, NPN BJT, etc.) and the term "MP" indicates a p-type transistor (e.g., PMOS, PNP BJT, etc.).

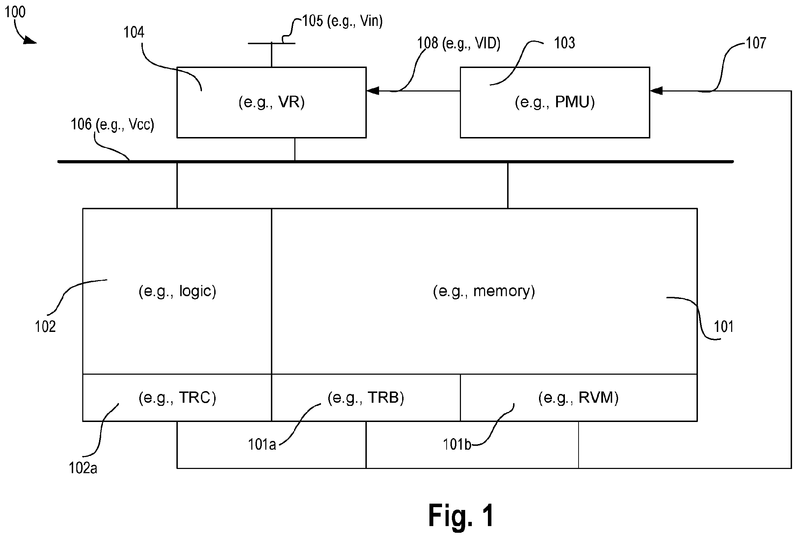

**Fig. 1** illustrates a high level architecture of an adaptive voltage system (AVS) 100, according to some embodiments of the disclosure. System 100 comprises an array of bit-cells 101, logic 102 (e.g., column multiplexers, decoders, etc.), TRB circuitry 101a, RVM circuitry 101b, TRC 102a, PMU circuitry 108, supply generator circuitry 104, input supply 105, output supply 106, monitor node 107, and supply control node 108.

In some embodiments, the array of bit-cells 101 is a memory array (e.g., content addressable memory (CAM), four transistor (4T) SRAM, 6T SRAM, 8T SRAM, register file (RF), dual-ported memory, etc.). In some embodiments, memory array 101 has associated TRB circuitry 101a and RVM circuitry 101b. In some embodiments, TRB circuitry 101a and RVM circuitry 101b may be fully integrated with the memory cells of memory array 101. In some embodiments, TRB circuitry 101a measures the speed/timing of the memory array's storage cells. In some embodiments, RVM circuitry 101b includes RVM cells which measure the Vmin needed by the memory cells of memory array 101 to keep or retain their data.

In some embodiments, logic 102 (which can be any logic in a chip) has an associated TRC 102a. In some embodiments, TRC 102a monitors the speed/timing of certain logic cells (e.g., transistors in an AND gate) in logic 102.

In some embodiments, PMU 103 (or power management controller or circuitry) is used to monitor the information or outputs of TRB circuitry 101a, RVM circuitry 101b, and TRC 102a on a regular basis (e.g., every few milliseconds, nanoseconds, and/or picoseconds) and controls the supply generator 104 to modulate the supply on one or more supply nodes. For simplicity purposes, one supply node 106 is shown as being shared for memory array 101 and logic 102. However, a semiconductor chip may have many voltage domains and different supply generators for providing supply to the different voltage domains. In that case, PMU 103 may instruct the different supply generators to adjust the supply to the different voltage domains according to monitoring circuitries such as TRB circuitry 101a, RVM circuitry 101b, and TRC 102a. In some embodiments, besides the RVM cell 101b failures, the supply voltage on node 106 can also be raised if either the TRB circuitry 101a or TRC 102a cells exhibit sufficient failures. As such, in some embodiments, each of these test cells 101a, 101b, and 102a are coupled to PMU 403 which controls the supply voltage via supply generator 404 in response to the outputs of test cells 101a, 101b, and 102a.

In some embodiments, supply generator 104 is a DC-DC converter that receives an input power supply on node 105 and generates a regulated supply on node 106. In some embodiments, supply generator 104 is a low drop-out (LDO) regulator. For example, supply generator 104 comprises a digital LDO, an analog LDO, or a combination of them. Any suitable supply generator may be used for generator 104 which is operable to modulate the supply on node 106 according to control 108.

In some embodiments, RVM circuitry 101b acts as a test cell associated with the memory array 101 that is designed to measure the minimum supply voltage at which the storage cells in the memory array 101 can reliably keep their stored information. Initially, in the early life of the semiconductor chip, RVM circuitry 101b indicates that the storage cells in the memory array 101 can retain their data with a particularly low supply voltage. In some embodiments, data from RVM circuitry 101b reaches PMU circuitry 103 via monitor node 107. In some embodiments, PMU circuitry 103 sets a low supply voltage for memory 101 and logic 102. As such, the above inefficiency is alleviated because the semiconductor chip (here, indicated by memory 101 and logic 102) is able to operate at a lower supply voltage during its early life.

Over time, as the semiconductor chip's transistors age, RVM circuitry 101b indicates that a higher supply voltage is needed on node 106 to ensure that the memory array cells will be able to keep their data. Data from the RVM circuitry 101b reaches PMU circuitry 103 which requests supply generator 104 to increase its supply voltage on node 106 to a higher voltage level. For example, PMU 103 provides a new voltage identification (VID) 108 to supply generator 104 to set the supply voltage on node 106 to a higher voltage.

This behavior increases over time with RVM circuitry 101b indicating an even higher voltage is needed and PMU circuitry 103 providing the higher voltage on node 106 over the lifetime of the semiconductor chip 100. In this manner, the aforementioned supply voltage inefficiency is avoided because the semiconductor chip 100 scales up its supply voltage on an as-needed basis rather than running its supply voltage at an end of life worst case level over its entire lifetime.

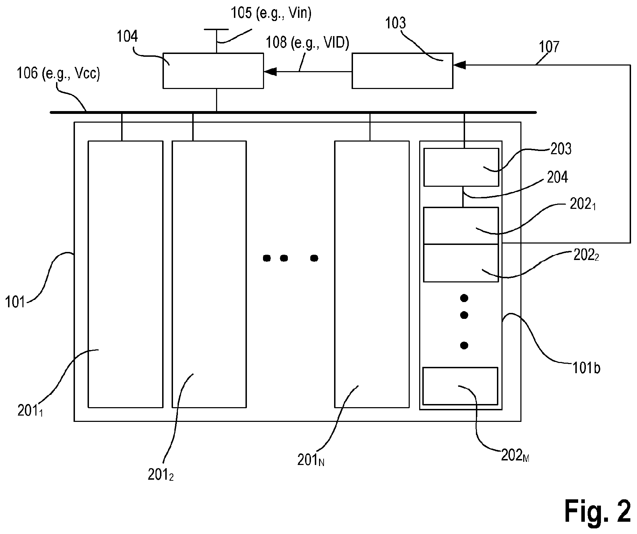

**Fig. 2** illustrates a high level architecture 200 of an adaptive voltage system with RVM for a memory array, according to some embodiments of the disclosure. It is pointed out that those elements of **Fig. 2** having the same reference numbers (or names) as the elements of any other figure can operate or function in any manner similar to that described, but are not limited to such.

Architecture 200 provides a detailed view of memory 101. In this example, RVM circuitry 101b is integrated within memory array 101. Memory 101 comprises rows/columns of memory bit-cells 201_{1-N}, where 'N' is an integer. In some embodiments, RVM circuitry 101b includes RVM bit-cells 202_{1-M}, where 'M' is an integer (e.g., M=16). In some embodiments, RVM bit-cells 202_{1-M} have the same circuitry as a memory bit-cell. For example, when a memory bit-cell is a 6T SRAM bit-cell, RVM bit-cell is also a 6T bit-cell. In some embodiments, RVM circuitry 101b includes a supply voltage modulator 203. In some embodiments, supply voltage modulator 203 receives a power supply from node 106 and modulates that power supply to stress the RVM bit-cells, and then to sample or sense the behavior of the stressed RVM bit-cells. For example, supply voltage modulator 203 receives voltage on node 106 and provides a supply 204 to RVM bit-cells 202_{1-M}.

In some embodiments, RVM circuitry 101b tracks the retention Vmin of RVM bit-cells 202_{1-M} which is affected by aging of transistors and other variations. Adaptive voltage system 200 samples the RVM output 107 periodically. Aging is a slow changing behavior, and so periodically sampling here may much slower than a clock frequency of the chip. For example, adaptive voltage system 200 samples the RVM output 107 every other day. When RVM circuitry 101b detects the Vmin change due to the aging, it provides a warning signal via node 107 to PMU 103 to adapt Vcc on node 106 by supply generator 104. Here, the same stress conditions are applied for the RVM aging sensor 101b and the memory bit-cells 201_{1-N}.

Here, storage cell failures are a function of manufacturing process variations that cause some transistors to age faster than other transistors. As such, having multiple RVM cells designed into a same semiconductor chip provides for a greater spread of RVM cell performance (e.g., some RVM cells will fail before other RVM cells), in accordance with some embodiments. The decision point as to when the supply voltage on node 106 should be raised because of RVM cell failure(s) can be a function of, for example, the number of RVM cells that have been observed to fail, in accordance with some embodiments.

For instance, if RVM cells 202_{1-M} are designed to be particularly weak during a measurement read (e.g., they have multiple pull-up transistors and a lowered read supply voltage), the decision to raise the supply voltage on node 106 may require failure of multiple RVM cells. In some embodiments, if RVM cells 202_{1-M} are designed to be less weak during a measurement read (e.g., only a small supply voltage drop is effected during a measurement read), the decision to raise the supply voltage may involve failure of fewer (e.g., just one) RVM cell from among RVM cells 202_{1-M}.

In some embodiments, the performance of RVM cells 202_{1-M} is averaged together by tying their input and output nodes together. In some embodiments, each RVM cell is effectively coupled in parallel in that its input and output nodes are coupled to the same node. Coupling RVM cells 202_{1-M} in this manner allows for multiple mechanisms to trigger an error during a measurement read, which, in turn, reflects the overall performance of the set of RVM cells 202_{1-M}, in accordance with some embodiments.

For example, in some embodiments, incorrect data may be read at the output if any of the following situations arise: more than half of RVM cells 202_{1-M} weakly fail (e.g., each cell only weakly pulls the output data nodes toward the wrong logic level but more than half of the cells pulling in this manner is sufficient to pull the entire data node to the wrong level), a few RVM cells 202_{1-M} fail with some strength (e.g., a few failing RVM cells pull the data output nodes with enough strength to over-ride the other correctly working RVM cells and place the output data nodes at the wrong logic level), or one RVM cell from among cells 202_{1-M} fails with tremendous strength (e.g., the one cell pulls the data output node with enough strength to over-ride all the other RVM cells).

In some embodiments, one or more sense amplifiers (not shown) associated with RVM bit-cells 202_{1-M} in RVM circuitry 101b are to determine a logic state stored in the RVM bit-cells 202_{1-M} before and after the application of the voltage and/or current stress to RVM bit-cells 202_{1-M}. As such, PMU 103 determines whether RVM bit-cells 202_{1-M} retained their data upon application of voltage and/or current stress through supply node 204.

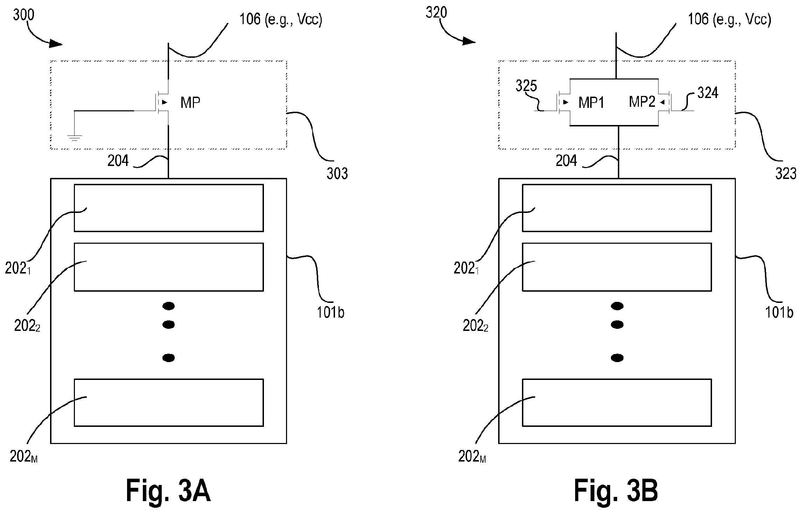

Figs. 3A-F illustrate RVM circuitries 300, 320, 330, 340, 350, and 360, respectively, according to various embodiments of the disclosure. It is pointed out that those elements of Figs. 3A-F having the same reference numbers (or names) as the elements of any other figure can operate or function in any manner similar to that described, but are not limited to such. All RVM circuitries track aging trend of retention Vmin of array 101.

RVM circuitry 300 of Fig. 3A illustrates an embodiment of supply voltage modulator 203 as circuit 303. Here, circuit 303 comprises a p-type device MP coupled to nodes 106 and 204. In some embodiments, the gate terminal of the p-type device MP is coupled to ground. In some embodiments, when the p-type device MP is fully turned on (e.g., when its gate is connected to ground), RVM bit-cells 202_{1-M} are stressed by the full amount of Vcc from node 106. In some embodiments, the p-type device MP is expected to reveal that a problem of aging is imminent at about the same time that the actual memory cells 201_{1-N} begin to fail. As such, the sensitivity level of tracking aging by circuit 303 is low which may leave the system little time to adjust its memory supply voltage 106.

In another embodiment, the gate of the p-type device MP is coupled to a control node which biases the p-type device MP. In some embodiments, the control voltage on the control node affects the supply voltage on node 204 that is provided to RVM bit-cells 202_{1-M}. For example, the control voltage on the control node merely weakly or modestly turns on the p-type device MP which increases its channel resistance thereby inducing a voltage drop across the p-type device MP. The voltage drop across the p-type device MP, in turn, lowers the supply voltage on node 204 that is applied to the storage cell. With a lowered supply voltage, the RVM cells 202_{1-M} exhibit failures before the actual storage cells 201_{1-N} in memory array 101. For example, the voltage margin of RVM cells 202_{1-M} is by design less than the voltage margin of the actual storage cells 201_{1-N} in the memory array 101.

However, because the RVM cells 202_{1-M} continuously receive the lower supply voltage, they may not be stressed to the same degree as the actual storage cells 201_{1-N} in the memory array 101 (which receive a higher supply from voltage from node 106 since their cells do not include the p-type device MP). The lesser stress received by RVM cells 202_{1-M} offsets its tendency to exhibit errors sooner because of its lesser supply voltage.

RVM circuitry 320 of Fig. 3B illustrates an embodiment of supply voltage modulator 203 as circuit 323 which comprises at least two p-type devices MP1 and MP2 coupled together in parallel, and controllable by two different control signals provided on nodes 325 and 324 respectively. RVM circuitry 320 combines the two embodiments of RVM circuitry 300 in which one p-type device MP1 is controlled by an analog signal provided to node 325 while the other device p-type MP2 is digitally controlled. In some embodiments, PMU 103 applies voltage stress to the RVM bit-cells 202_{1-M} by turning on p-type device MP2 324. In some embodiments, PMU 103 senses the retention capability of RVM cells 202_{1-M} by turning off p-type device MP2 and providing an analog voltage to the gate terminal of p-type device MP1 so that RVM bit-cells 202_{1-M} are more sensitive to retention failure. The more sensitive the sensing mechanism for retention failure, the earlier the detection of the failure is, in according with various embodiments. In some embodiments, a bias circuit (or a programmable voltage divider) is used to provide the bias voltage on node 325.

While the various embodiments here describe the supply voltage modulator 203 as having only p-type transistors, in some embodiments n-type transistors may also be used alone or in combination of p-type transistors to provide voltage stress to the bit-cells and to then sense the retention failures. Further, the illustration of a single transistor can be replaced with multiple transistors coupled in parallel and controllable to be turned on to adjust the stress level and/or the retention sensitivity level, in accordance with various embodiments.

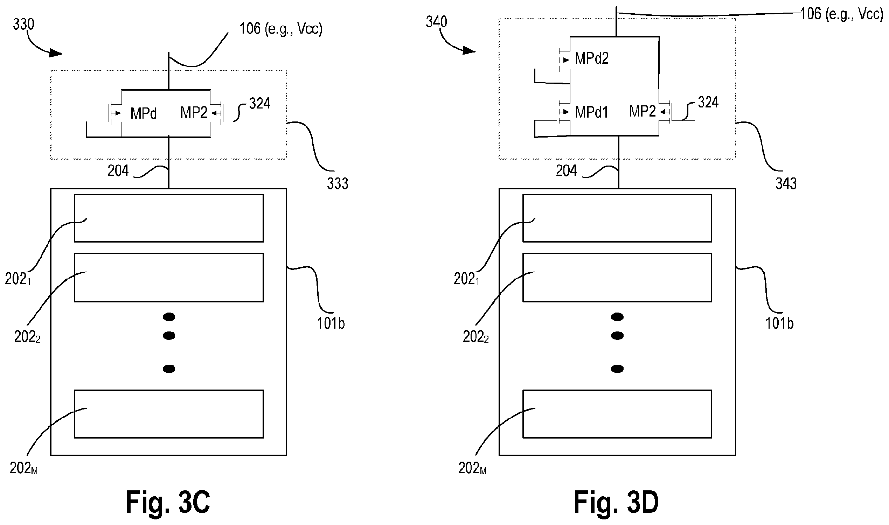

RVM circuitry 330 of Fig. 3C illustrates an embodiment of supply voltage modulator 203 as circuit 333 which comprises a diode-connected device MPd coupled in parallel to device MP2 which is controlled by node 324. In some embodiments, the diode-connected device MPd causes a forward bias voltage drop to occur on the supply voltage rail that feeds the RVM storage cells 201_{1-M} while their stored data are being read during a measurement or sampling mode.

In some embodiments, the supply voltage path to the RVM storage cells 201_{1-M} includes two electrical paths. The first path is through device MP2 that applies the full supply voltage to RVM storage cells 201_{1-M} to stress the cells approximately the same way the actual storage cells 201_{1-N} in the memory array 101 are being stressed. The second path is through the diode-connected device MPd that applies a lowered supply voltage to the RVM storage cells 201_{1-M} when it is being measured to understand, at current stress levels, if the lowered supply voltage is sufficiently low to cause RVM storage cells 201_{1-M} to fail to store their data correctly. If so, the RVM storage cells 201_{1-M} will have provided an "early warning" that the supply voltage has not yet reached, but will soon reach, a level where the cells 101_{1-N} of the memory array 101 will begin to exhibit errors. With a viable early warning indicator, the supply voltage can be raised before any cells in the memory array actually begin to fail.

In some embodiments, in the sampling mode, device MP2 is turned off to force the supply current to flow from node 106 to node 204 through diode-connected device MPd thereby inducing the aforementioned supply voltage drop. In some embodiments, the supply voltage drop induced by the diode-connected device MPd "weakens" the RVM cell's ability to keep its stored data, similar to the control device MP1 of **Fig. 3B****.**

Referring back to **Fig. 3C****,** in some embodiments, the RVM cells 202_{1-M} are merely weakened with a lesser supply voltage for the read operation performed during the measurement mode (also referred to as the sampling or sensing mode). In some embodiments, during the stress mode, RVM cells 202_{1-M} are not substantially supplied through the diode-connected device MPd but are instead supplied through the stress device MP2 which is strongly turned on while the RVM cells 202_{1-M} are being stressed. Because the stress device MP2 is strongly on during the stress mode, it has very low channel resistance and thereby negligible voltage drop across it, in accordance with some embodiments.

As such, during the stress mode, RVM cells 202_{1-M} receive the full Vcc supply voltage via node 204. As mentioned here, to measure the cell's stored data during (e.g., periodic) measurement modes in between extended stress times, the stress device MP2 is turned off which forces all supply current to flow through the diode-connected device MPd which weakens the cell by lowering its supply voltage during the read mode, in accordance with some embodiments.

RVM circuitry 340 of **Fig. 3D** illustrates an embodiment of supply voltage modulator 203 as circuit 343 which comprises two or more series coupled diode-connected devices MPd1 and MPd2, which are together coupled in parallel to device MP2 which is controlled by voltage/current on node 324. In this example, two diode-connected devices coupled in series are shown. However, more than two such devices can also be coupled in series to adjust the sensitivity level for retention failure.

Like RVM circuitry 330, RVM circuitry 340 induces a voltage drop along the supply voltage path during measurement read mode but induces even more supply voltage drop than the circuit of **Fig. 3C****,** in accordance with some embodiments. For example, whereas RVM circuitry 330 of **Fig. 3C** induces one forward bias voltage drop along the supply rail during a test mode, by contrast, RVM circuitry 340 induces two forward bias voltage drops along the supply rail during a test mode by way of a pair of diode-connected devices MPd1 and MPd2. As such, RVM circuitry 340 may provide an even earlier warning signal than RVM circuitry 330, in accordance with some embodiments. While the embodiment of **Fig. 3D** illustrates two diode-connected devices coupled in series, more diode connected devices may be cascoded in series to further increase the retention failure sensitivity.

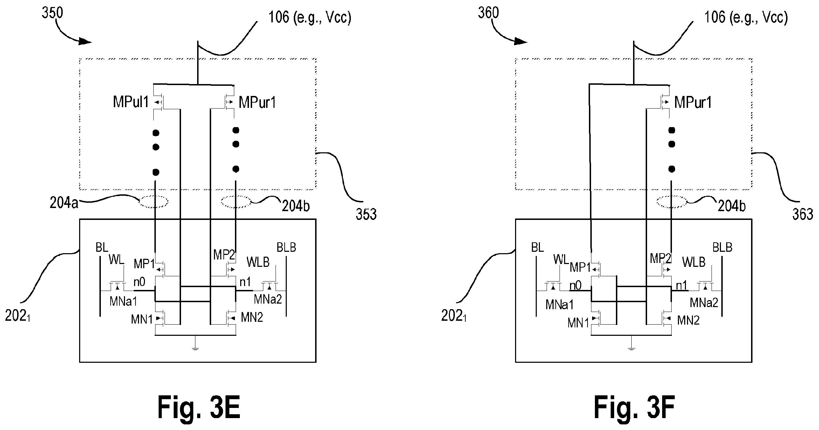

RVM circuitry 350 of **Fig. 3E** illustrates an embodiment of supply voltage modulator 203 as circuit 353 which comprises multiple pull-up devices (e.g., MPul1 and MPur1) along each leg (e.g., right and left legs) instead of merely a single pull-up transistor along each leg. Here, the term "leg" generally refers to the electrical path of transistors MP1 and MN1 of a RVM bit cell to ground or lower potential node, or electrical path of devices MP2 and MN2 of the RVM bit cell to ground or lower potential node. In this example, a 6T RVM bit-cell is shown, however, the embodiments are applicable to 4T SRAM, 8T SRAM, dual-port, or CAM bit-cell, etc. The 6T RVM bit-cell 202₁ comprises bit-line BL, bit-line bar BLB (which provides a signal which is an inverse of the signal on BL), word line (WL), word line bar (WLB) (which provides a signal which is an inverse of the signal on WLB), access devices MNa1 and MNa2, cross-coupled inverting devices MP1, MN1, MP2, and MN2, and storage nodes n0 and n1 coupled together as shown.

In some embodiments, the more pull-up transistors that are chained together, the weaker their pull-up effect. As such, the output nodes n0 and n1 of RVM cell 202₁ have a propensity to be pulled down rather than pulled-up, in accordance with some embodiments. If, for instance, the gain of the pull-up transistors 353 diminish through aging, the RVM cell 202₁ may reach a point where one of its output nodes is not able to be pulled up to a logic high when a logic high at the output node corresponds to correctly stored data. Upon such a point being reached, RVM cell 202₁ is failing which corresponds to a warning signal that the supply voltage on node 106 to memory array 101 should be raised soon.

In some embodiments, RVM circuitry 350 does not include a voltage drop along its supply rail (e.g., nodes 204a and 204b) during read mode. For example, RVM cell 202₁ is weakened with extra pull-up transistors of circuitry 353 rather than with a lower supply voltage. As such circuitry 353 may not need two supply paths as with the approaches of **Figs. 3B-D****.** Referring back to **Fig. 3E**, in some embodiments, RVM cell 202₁ is tied directly to the supply voltage, and so its constituent transistors are stressed in-step with the transistors of the actual storage cells 201_{1-N} in memory array 101.

RVM circuitry 360 of **Fig. 3F** illustrates an embodiment of supply voltage modulator 203 as circuit 363 which comprises multiple pull-up devices (e.g., device MPur1) along one leg. For example, multiple pull-up devices are coupled between nodes 106 and 204b. In some embodiments, RVM storage cell 202₁ is differential in that the storage of data is effected by one leg keeping a logic high and the other leg keeping a logic low. For example, the operation of RVM storage cell 202₁ can be viewed as being balanced. With merely one leg having multiple pull-up devices MPur1, the balanced nature of RVM storage cell 202₁ may be adversely affected. For example, the leg having multiple pull-up transistors 363 may have less of an ability to pull-up its output node (n0 or n1) to a logic high than the leg having only one pull-up device (e.g., device MPupl).

With this imbalance or asymmetry, RVM storage cell 202₁ may not be able to store a logic value that corresponds to a logic high value on the leg with multiple pull-up transistors (a first state) as reliably as it can store a logic value that corresponds to a logic low value on the leg with multiple pull-up transistors (a second state), in accordance with some embodiments. For example, RVM storage cell 202₁ may have a tendency to stick in the second state rather than the first state. In some embodiments, RVM storage cell 202₁ is loaded with data that corresponds to the first state and when RVM storage cell 202₁ is observed to have flipped to the second state, the failure corresponds to an early warning sign that the supply voltage should be raised soon. In some embodiments, circuitry 363 may not need two supply paths as with the approaches of **Figs. 3B-D** because RVM storage cell 202₁ is tied directly to the supply voltage on node 106. As such, RVM storage cell 202₁ transistors are stressed in-step with the transistors of the actual storage cells 201_{1-N} in memory array 101.

Some embodiments here are merely some of the ways in which an RVM storage cell can be weakened for its measurement read but will still be stressed at full supply voltage and that a vast number of other RVM cell designs may be utilized to achieve this particular objective of various embodiments.

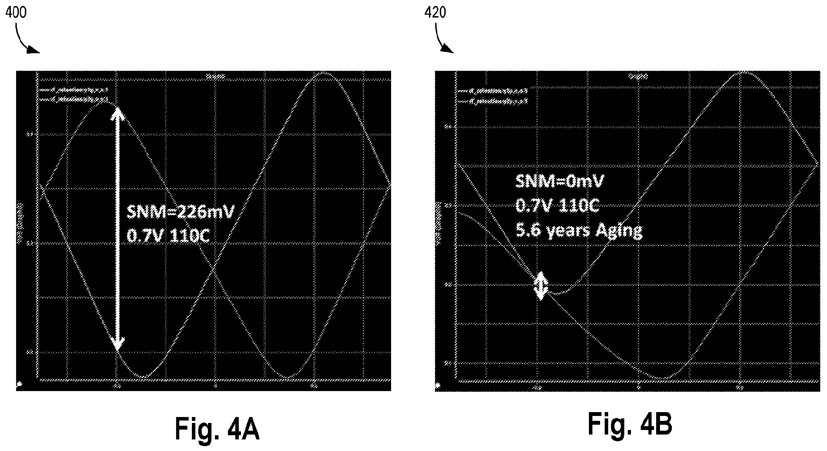

**Figs. 4A-B** illustrate plots 400 and 420 showing static noise margin (SNM) before and after aging, respectively. **Fig. 4A** shows the SNM of 226 mV before aging at 0.7 V and 110°C temperature, while **Fig. 4B** shows zero SNM of memory array 101 after 5.6 year aging which fails to retain the data in memory array 101. Various embodiments use RVM circuitry 101b to maintain a descent SNM over a lifetime of the IC.

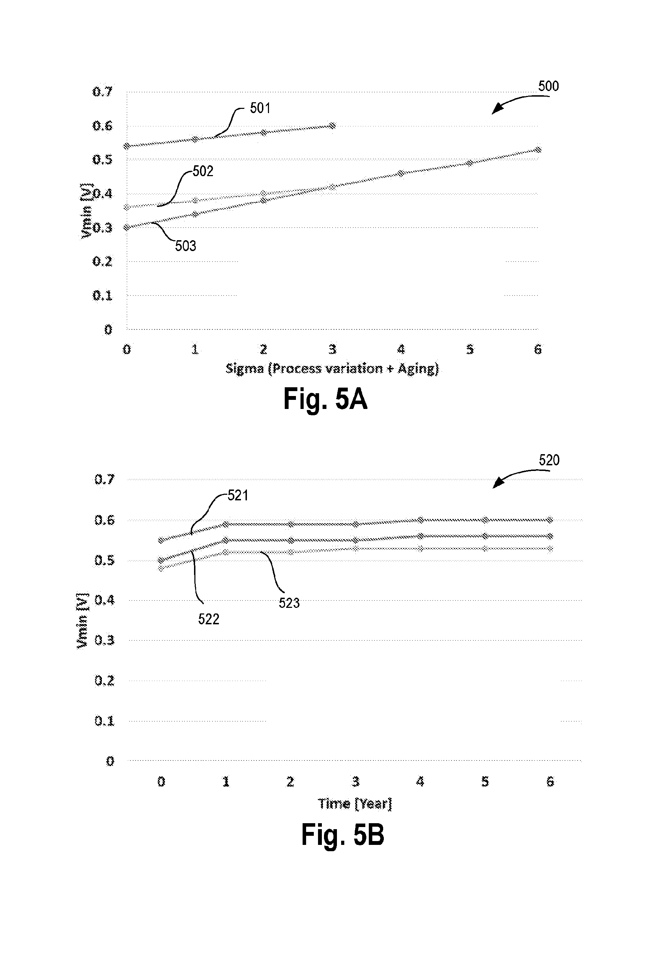

**Fig. 5A** illustrates plot 500 showing Vmin for a memory array across process variation and aging, according to some embodiments. Plot 500 shows that two retention Vmin monitors track retention Vmin of a memory array across process corner with small amount of difference (e.g., sigma). In this example, each RVM has different Vmin tracking. Waveform 501 is the Vmin for a two stack diode-connected RVM (e.g., **Fig. 3D**), waveform 502 is the Vmin for a one stack diode-connected RVM (e.g., **Fig. 3C**), and waveform 503 is the Vmin for a memory bit-cell (e.g., 201₁). Based on the simulation results, 2-stacked diode-connected RVM shows better tracking with the smallest margin across process and aging variation. Here, the 2-stack diode-connected RVM (e.g., **Fig. 3D**) with 0 to approximate 3 sigma has little higher Vmin than Vmin of bit-cell with 6 sigma.

**Fig. 5B** illustrates plot 520 showing Vmin with aging period for a memory bit-cell and two stack diode-connected RVM, according to some embodiments. Waveform 521 is the Vmin for a two stack diode-connected RVM (e.g., **Fig. 3D**) with signal 3, waveform 522 is the Vmin for a two stack diode-connected RVM (e.g., **Fig. 3D**) with sigma 1, and waveform 523 is the Vmin for a memory bit cell (e.g., 201₁). Plot 520 shows the Vmin trend with 2-stacked diode-connected RVM and array 101, where Vmin of RVM and array increases over years. Here, RVM tracks retention Vmin of array well across process corner.

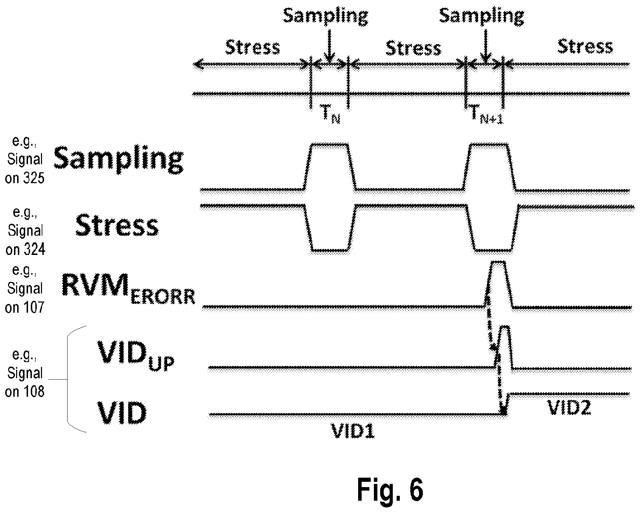

**Fig. 6** illustrates plot 600 with waveforms showing sampling and stress timing diagram, according to some embodiments of the disclosure. It is pointed out that those elements of **Fig. 6** having the same reference numbers (or names) as the elements of any other figure can operate or function in any manner similar to that described, but are not limited to such. Here, x-axis is time and y-axis for each waveform is voltage. By choosing sampling and stress signal on p-type device header of RVM circuitry 203, an RVM bit-cell 202₁ is stressed with full swing and sampling the retention Vmin of a bit-cell 202₁ continuously. In some embodiments, when RVM error signals before array function fails, PMU 103 changes voltage level (e.g., by changing VID code) via 108 for voltage generator 104 until error signal on node 107 is gone.

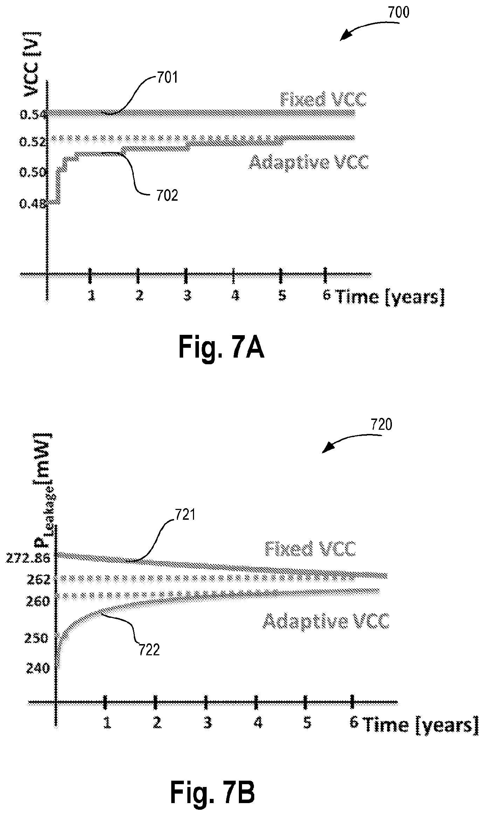

**Figs. 7A-B** illustrate plots 700 and 720 showing power savings using the RVM circuitries of various embodiments, respectively. Plot 700 shows fixed Vcc 701 and adaptive Vcc on node 106 over time as regulated using RVM circuitry 101b via PMU 103 and supply generator 104. Plot 720 illustrates the corresponding power associated with fixed Vcc 721 and adaptive Vcc 722 on node 106. Adaptive voltage scaling (AVS) of various embodiments can start lower Vcc than fixed Vcc scenario which deposits aging guardband or margin from the beginning. Because of lower Vcc starting, AVS consumes less power during entire usage of the IC, in accordance with some embodiments.

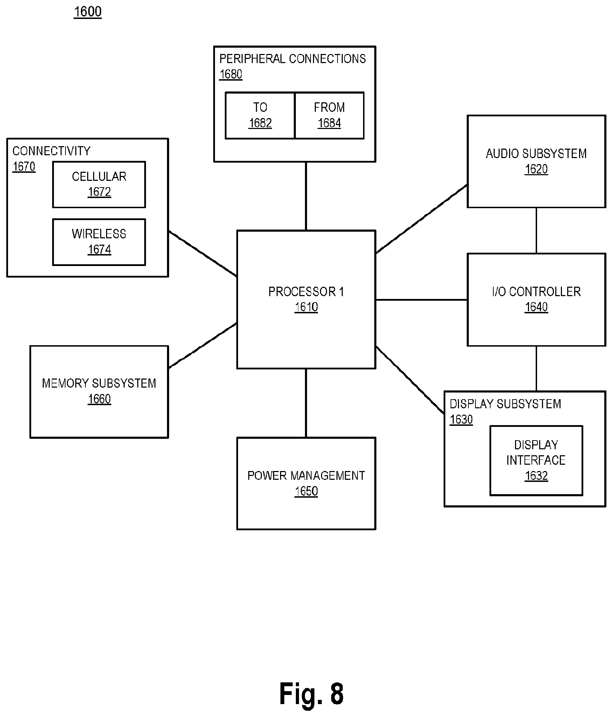

**Fig. 8** illustrates a smart device or a computer system or a SoC (System-on-Chip) with the adaptive voltage system, according to some embodiments. It is pointed out that those elements of **Fig. 8** having the same reference numbers (or names) as the elements of any other figure can operate or function in any manner similar to that described, but are not limited to such.

**Fig. 8** illustrates a block diagram of an embodiment of a mobile device in which flat surface interface connectors could be used. In some embodiments, computing device 1600 represents a mobile computing device, such as a computing tablet, a mobile phone or smart-phone, a wireless-enabled e-reader, or other wireless mobile device. It will be understood that certain components are shown generally, and not all components of such a device are shown in computing device 1600.

In some embodiments, computing device 1600 includes first processor 1610 with the adaptive voltage system, according to some embodiments discussed. Other blocks of the computing device 1600 may also include the adaptive voltage system, according to some embodiments. In some embodiments, the entire SoC is provided with the adaptive voltage system. The various embodiments of the present disclosure may also comprise a network interface within 1670 such as a wireless interface so that a system embodiment may be incorporated into a wireless device, for example, cell phone or personal digital assistant.

In some embodiments, processor 1610 can include one or more physical devices, such as microprocessors, application processors, microcontrollers, programmable logic devices, or other processing means. The processing operations performed by processor 1610 include the execution of an operating platform or operating system on which applications and/or device functions are executed. The processing operations include operations related to I/O (input/output) with a human user or with other devices, operations related to power management, and/or operations related to connecting the computing device 1600 to another device. The processing operations may also include operations related to audio I/O and/or display I/O.

In some embodiments, computing device 1600 includes audio subsystem 1620, which represents hardware (e.g., audio hardware and audio circuits) and software (e.g., drivers, codecs) components associated with providing audio functions to the computing device. Audio functions can include speaker and/or headphone output, as well as microphone input. Devices for such functions can be integrated into computing device 1600, or connected to the computing device 1600. In one embodiment, a user interacts with the computing device 1600 by providing audio commands that are received and processed by processor 1610.

In some embodiments, computing device 1600 comprises display subsystem 1630. Display subsystem 1630 represents hardware (e.g., display devices) and software (e.g., drivers) components that provide a visual and/or tactile display for a user to interact with the computing device 1600. Display subsystem 1630 includes display interface 1632, which includes the particular screen or hardware device used to provide a display to a user. In one embodiment, display interface 1632 includes logic separate from processor 1610 to perform at least some processing related to the display. In one embodiment, display subsystem 1630 includes a touch screen (or touch pad) device that provides both output and input to a user.

In some embodiments, computing device 1600 comprises I/O controller 1640. I/O controller 1640 represents hardware devices and software components related to interaction with a user. I/O controller 1640 is operable to manage hardware that is part of audio subsystem 1620 and/or display subsystem 1630. Additionally, I/O controller 1640 illustrates a connection point for additional devices that connect to computing device 1600 through which a user might interact with the system. For example, devices that can be attached to the computing device 1600 might include microphone devices, speaker or stereo systems, video systems or other display devices, keyboard or keypad devices, or other I/O devices for use with specific applications such as card readers or other devices.

As mentioned above, I/O controller 1640 can interact with audio subsystem 1620 and/or display subsystem 1630. For example, input through a microphone or other audio device can provide input or commands for one or more applications or functions of the computing device 1600. Additionally, audio output can be provided instead of, or in addition to display output. In another example, if display subsystem 1630 includes a touch screen, the display device also acts as an input device, which can be at least partially managed by I/O controller 1640. There can also be additional buttons or switches on the computing device 1600 to provide I/O functions managed by I/O controller 1640.

In some embodiments, I/O controller 1640 manages devices such as accelerometers, cameras, light sensors or other environmental sensors, or other hardware that can be included in the computing device 1600. The input can be part of direct user interaction, as well as providing environmental input to the system to influence its operations (such as filtering for noise, adjusting displays for brightness detection, applying a flash for a camera, or other features).

In some embodiments, computing device 1600 includes power management 1650 that manages battery power usage, charging of the battery, and features related to power saving operation. Memory subsystem 1660 includes memory devices for storing information in computing device 1600. Memory can include nonvolatile (state does not change if power to the memory device is interrupted) and/or volatile (state is indeterminate if power to the memory device is interrupted) memory devices. Memory subsystem 1660 can store application data, user data, music, photos, documents, or other data, as well as system data (whether long-term or temporary) related to the execution of the applications and functions of the computing device 1600.

Elements of embodiments are also provided as a machine-readable medium (e.g., memory 1660) for storing the computer-executable instructions (e.g., instructions to implement any other processes discussed herein). The machine-readable medium (e.g., memory 1660) may include, but is not limited to, flash memory, optical disks, CD-ROMs, DVD ROMs, RAMs, EPROMs, EEPROMs, magnetic or optical cards, phase change memory (PCM), or other types of machine-readable media suitable for storing electronic or computer-executable instructions. For example, embodiments of the disclosure may be downloaded as a computer program (e.g., BIOS) which may be transferred from a remote computer (e.g., a server) to a requesting computer (e.g., a client) by way of data signals via a communication link (e.g., a modem or network connection).

In some embodiments, computing device 1600 comprises connectivity 1670. Connectivity 1670 includes hardware devices (e.g., wireless and/or wired connectors and communication hardware) and software components (e.g., drivers, protocol stacks) to enable the computing device 1600 to communicate with external devices. The computing device 1600 could be separate devices, such as other computing devices, wireless access points or base stations, as well as peripherals such as headsets, printers, or other devices.

Connectivity 1670 can include multiple different types of connectivity. To generalize, the computing device 1600 is illustrated with cellular connectivity 1672 and wireless connectivity 1674. Cellular connectivity 1672 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, or other cellular service standards. Wireless connectivity (or wireless interface) 1674 refers to wireless connectivity that is not cellular, and can include personal area networks (such as Bluetooth, Near Field, etc.), local area networks (such as Wi-Fi), and/or wide area networks (such as WiMax), or other wireless communication.

In some embodiments, computing device 1600 comprises peripheral connections 1680. Peripheral connections 1680 include hardware interfaces and connectors, as well as software components (e.g., drivers, protocol stacks) to make peripheral connections. It will be understood that the computing device 1600 could both be a peripheral device ("to" 1682) to other computing devices, as well as have peripheral devices ("from" 1684) connected to it. The computing device 1600 commonly has a "docking" connector to connect to other computing devices for purposes such as managing (e.g., downloading and/or uploading, changing, synchronizing) content on computing device 1600. Additionally, a docking connector can allow computing device 1600 to connect to certain peripherals that allow the computing device 1600 to control content output, for example, to audiovisual or other systems.

In addition to a proprietary docking connector or other proprietary connection hardware, the computing device 1600 can make peripheral connections 1680 via common or standards-based connectors. Common types can include a Universal Serial Bus (USB) connector (which can include any of a number of different hardware interfaces), DisplayPort including MiniDisplayPort (MDP), High Definition Multimedia Interface (HDMI), Firewire, or other types.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional element.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

## Claims

1. An apparatus (100) for aging guard-band reduction, the apparatus comprising:
a first power supply node (106);
a second power supply node (204);
a memory bit-cell (202) coupled to the second power supply node (204);
a circuitry coupled to the first and second power supply nodes (106, 204), the circuitry to operate in a diode-connected mode;
a transistor coupled in parallel to the circuitry, wherein the transistor is controllable by a digital signal such that when the transistor is to turn on, it is to apply voltage and/or current stress to the memory bit-cell (202); and
a sense amplifier to determine a logic state stored in the memory bit-cell (202) before and after the application of the voltage and/or current stress by way of the transistor to the memory bit-cell (202),
wherein the apparatus further comprises a power management circuitry (103) to generate the digital signal such that the transistor is to turn on in a low power mode or retention mode, and to turn off in a normal mode or active mode.

2. The apparatus of claim 1 comprises:
a voltage regulator (104) coupled to the power management circuitry (103), wherein the voltage regulator is to provide a power supply to the first power supply node (106).

3. The apparatus of claim 2, wherein:
the power management circuitry (103) is to instruct the voltage regulator (106) to adjust the power supply according to an output of the sense amplifier associated with the memory bit-cell (202), or
the power management circuitry (103) is to adjust a value of a voltage identification, VID, code to adjust the power supply.

4. The apparatus according to any one of claims 1 to 3, wherein the power management circuitry (103) is to cause a power supply on the first power supply node (106) to rise gradually over time.

5. The apparatus according to any one of claims 1 to 3, wherein the memory bit-cell (202) is a static random access memory bit-cell.

6. The apparatus according to any one of claims 1 to 3, wherein the circuitry comprises one of: a stack of diode-connected transistors, or a single diode-connected transistor.

7. The apparatus according to any one of claims 1 to 3, wherein the circuitry and the transistor are shared by a column of memory bit-cells including the memory bit-cell (202), and wherein one or more sensing amplifiers including the sense amplifier are to determine a logic state stored in the column of memory bit-cells before and after the application of voltage and/or current stress to the bit cells to provide an early detection of memory failure during standby or retention mode.

8. The apparatus according to claim 1 comprising:
a retention Vₘᵢₙ monitor, RVM (101b), coupled to a memory, wherein the RVM is to detect an aging failure of the memory, wherein the RVM and the memory are coupled to the first power supply node, and wherein the RVM comprises:
the memory bit-cell (202) coupled to a second power supply node;
the circuitry coupled to the first and second power supply nodes (106, 204), the circuitry to operate in the diode-connected mode; and
the transistor coupled in parallel to the circuitry.

9. The apparatus of claim 8 comprises:
a tunable replica bit, TRB, circuitry (101a) coupled to a memory, wherein the TRB circuitry is to detect timing margin for the memory by measuring a speed/timing of the memory array's storage cells;
a tunable replica circuit, TRC, (102a) coupled to a logic block, wherein the TRC is to detect a timing margin and error in advance for the logic block by measuring the speed/timing of certain logic cells of the logic block, wherein the logic block and the TRC are coupled to the first power supply node; and
wherein the power management circuitry (103) is communicatively coupled to the TRB circuitry, TRC, and RVM.

10. The apparatus of claim 9 comprises a voltage regulator (104) coupled to the power management circuitry (103), wherein the power management circuitry (103) is to cause the voltage regulator (104) to modulate a power supply provided to the first power supply node (106) according to outputs of the TRB, TRC, and RVM.

11. The apparatus of claim 1 comprising:
a voltage regulator (104), the first power supply node (106) coupled to the voltage regulator (104), wherein the power management circuitry (103) is coupled to the voltage regulator (104);
and
a processor coupled to the first power supply node (106) and the power management circuitry (103), wherein the processor includes a memory having the memory bit-cell (202), wherein the processor comprises:
the circuitry coupled to the first and second power supply nodes, the circuitry to operate in a diode-connected mode; and
the transistor coupled in parallel to the circuitry, wherein the transistor is controllable by the digital signal such that when the transistor is to turn on, it is to apply voltage and/or current stress to the memory bit-cell.

12. The apparatus of claim 11, comprising a wireless interface to allow the processor to communicate with another device.

13. A system comprising:
a memory;
a processor coupled to the memory, the processor including an apparatus for aging guard-band reduction, the apparatus according to any one of claims 1 to 10, the memory being coupled to the first supply node; and
wireless interface to allow the processor to communicate with another device.

## Patentansprüche

1. Einrichtung (100) für eine Verringerung der Alterungsreserve, wobei die Einrichtung umfasst:
einen ersten Stromversorgungsknoten (106);
einen zweiten Stromversorgungsknoten (204);
eine Speicherbitzelle (202), die mit dem zweiten Stromversorgungsknoten (204) gekoppelt ist;
eine Schaltungsanordnung, die mit dem ersten und dem zweiten Stromversorgungsknoten (106, 204) gekoppelt ist, wobei die Schaltungsanordnung geeignet ist, um in einem Diodenschaltungsmodus zu funktionieren;
einen Transistor, der zu der Schaltungsanordnung parallel geschaltet ist, wobei der Transistor durch ein digitales Signal so steuerbar ist, dass, wenn der Transistor eingeschaltet wird, er geeignet ist, um eine Spannungs- und/oder Strombelastung an die Speicherbitzelle anzulegen (202); und
einen Leseverstärker, der geeignet ist, um einen Logikzustand, der in der Speicherbitzelle (202) gespeichert ist, vor und nach dem Anlegen der Spannungs- und/oder Strombelastung über den Transistor an die Speicherbitzelle (202) zu ermitteln,
wobei die Einrichtung ferner eine Stromverwaltungsschaltungsanordnung (103) umfasst, um das digitale Signal so zu erzeugen, dass der Transistor in einem Niedrigleistungsmodus oder einem Aufbewahrungsmodus eingeschaltet wird und in einem Normalmodus oder einem Aktivmodus ausgeschaltet wird.

2. Einrichtung nach Anspruch 1, die umfasst:
einen Spannungsregler (104), der mit der Stromverwaltungsschaltungsanordnung (103) gekoppelt ist, wobei der Spannungsregler geeignet ist, um eine Stromversorgung für den ersten Stromversorgungsknoten (106) bereitzustellen.

3. Einrichtung nach Anspruch 2, wobei:
die Stromverwaltungsschaltungsanordnung (103) geeignet ist, um den Spannungsregler (106) anzuweisen, die Stromversorgung gemäß einer Ausgabe des Leseverstärkers anzupassen, der mit der Speicherbitzelle (202) assoziiert ist, oder
die Stromverwaltungsschaltungsanordnung (103) geeignet ist, um einen Wert eines Spannungsidentifikations-Codes, VID-Codes, zum Anpassen der Stromversorgung anzupassen.

4. Einrichtung nach einem der Ansprüche 1 bis 3, wobei die Stromverwaltungsschaltungsanordnung (103) geeignet ist, um zu veranlassen, dass eine Stromversorgung an dem ersten Stromversorgungsknoten (106) im Laufe der Zeit stetig ansteigt.

5. Einrichtung nach einem der Ansprüche 1 bis 3, wobei die Speicherbitzelle (202) eine Bitzelle eines statischen Direktzugriffsspeichers ist.

6. Einrichtung nach einem der Ansprüche 1 bis 3, wobei die Schaltungsanordnung einen umfasst von: einem Stapel von als Dioden geschalteten Transistoren oder einem einzelnen als Diode geschalteten Transistor.

7. Einrichtung nach einem der Ansprüche 1 bis 3, wobei die Schaltungsanordnung und der Transistor von einer Spalte von Speicherbitzellen, welche die Speicherbitzelle (202) aufweisen, gemeinsam genutzt werden, und wobei ein oder mehrere Erfassungsverstärker, die den Erfassungsverstärker aufweisen, geeignet sind, um einen Logikzustand, der in der Spalte von Speicherbitzellen gespeichert ist, vor und nach dem Anlegen einer Spannungs- und/oder Strombelastung an die Bitzellen zu ermitteln, um eine frühe Erkennung eines Speicherausfalls während des Standby- oder Aufbewahrungsmodus bereitzustellen.

8. Einrichtung nach Anspruch 1, die umfasst:
einen Aufbewahrungs-Vₘᵢₙ-Monitor, RVM (101b), der mit einem Speicher gekoppelt ist, wobei der RVM geeignet ist, um einen Alterungsfehler des Speichers zu erkennen, wobei der RVM und der Speicher mit dem ersten Stromversorgungsknoten gekoppelt sind und wobei der RVM umfasst:
die Speicherbitzelle (202), die mit einem zweiten Stromversorgungsknoten gekoppelt ist;
die Schaltungsanordnung, die mit dem ersten und dem zweiten Stromversorgungsknoten (106, 204) gekoppelt ist, wobei die Schaltungsanordnung geeignet ist, um in dem Diodenschaltungsmodus zu funktionieren; und
den Transistor, der zu der Schaltungsanordnung parallel geschaltet ist.

9. Einrichtung nach Anspruch 8, die umfasst:
eine abstimmbare Replika-Bit-Schaltungsanordnung, TRB-Schaltungsanordnung (101a), die mit einem Speicher gekoppelt ist, wobei die TRB-Schaltungsanordnung geeignet ist, um eine Zeitreserve für den Speicher zu erkennen, indem eine Geschwindigkeit/Zeitsteuerung der Speicherzellen des Speicherarrays gemessen wird;
eine abstimmbare Replika-Schaltung, TRC, (102a), die mit einem Logikblock gekoppelt ist, wobei die TRC geeignet ist, um eine Zeitreserve und einen Fehler im Voraus für den Logikblock zu erkennen, indem die Geschwindigkeit/Zeitsteuerung von bestimmten Logikzellen des Logikblocks gemessen wird, wobei der Logikblock und die TRC mit dem ersten Stromversorgungsknoten gekoppelt sind; und
wobei die Stromverwaltungsschaltungsanordnung (103) mit der TRB-Schaltungsanordnung, der TRC, und dem RVM kommunikativ gekoppelt ist.

10. Einrichtung nach Anspruch 9, die einen Spannungsregler (104) umfasst, der mit der Stromverwaltungsschaltungsanordnung (103) gekoppelt ist, wobei die Stromverwaltungsschaltungsanordnung (103) geeignet ist, um zu veranlassen, dass der Spannungsregler (104) eine Stromversorgung moduliert, die dem ersten Stromversorgungsknoten (106) gemäß den Ausgaben des TRB, der TRC und des RVM bereitgestellt wird.

11. Einrichtung nach Anspruch 1, die umfasst:
einen Spannungsregler (104), wobei der erste Stromversorgungsknoten (106) mit dem Spannungsregler (104) gekoppelt ist, wobei die Stromverwaltungsschaltungsanordnung (103) mit dem Spannungsregler (104) gekoppelt ist;
und
einen Prozessor, der mit dem ersten Stromversorgungsknoten (106) und der Stromverwaltungsschaltungsanordnung (103) gekoppelt ist, wobei der Prozessor einen Speicher aufweist, der die Speicherbitzelle (202) aufweist, wobei der Prozessor umfasst:
die Schaltungsanordnung, die mit dem ersten und dem zweiten Stromversorgungsknoten gekoppelt ist, wobei die Schaltungsanordnung geeignet ist, um in einem Diodenschaltungsmodus zu funktionieren; und
den Transistor, der zu der Schaltungsanordnung parallel geschaltet ist, wobei der Transistor durch das digitale Signal so steuerbar ist, dass, wenn der Transistor eingeschaltet wird, er eine Spannungs- und/oder Strombelastung an die Speicherbitzelle anlegt.

12. Einrichtung nach Anspruch 11, die eine drahtlose Schnittstelle umfasst, um dem Prozessor zu erlauben, mit einer anderen Vorrichtung zu kommunizieren.

13. System, umfassend:
einen Speicher;
einen Prozessor, der mit dem Speicher gekoppelt ist, wobei der Prozessor eine Einrichtung für eine Verringerung der Alterungsreserve aufweist, wobei die Einrichtung eine nach einem der Ansprüche 1 bis 10 ist, wobei der Speicher mit dem ersten Versorgungsknoten gekoppelt ist; und
eine drahtlose Schnittstelle, um dem Prozessor zu erlauben, mit einer anderen Vorrichtung zu kommunizieren.

## Revendications

1. Appareil (100) de réduction de bande de garde de vieillissement, l'appareil comprenant :
un premier nœud (106) d'alimentation ;
un deuxième nœud (204) d'alimentation ;
une cellule binaire (202) de mémoire couplée au deuxième nœud (204) d'alimentation ;
une circuiterie couplée aux premier et deuxième nœuds (106, 204) d'alimentation, la circuiterie devant fonctionner dans un mode connecté en diode ;
un transistor couplé en parallèle à la circuiterie, le transistor pouvant être commandé par un signal numérique de sorte que, lorsque le transistor doit devenir passant, il doit appliquer une contrainte de tension et/ou de courant à la cellule binaire (202) de mémoire ; et
un amplificateur de lecture pour déterminer un état logique stocké dans la cellule binaire (202) de mémoire avant et après l'application de la contrainte de tension et/ou de courant par l'intermédiaire du transistor à la cellule binaire (202) de mémoire,
l'appareil comprenant en outre une circuiterie (103) de gestion de puissance pour générer le signal numérique de sorte que le transistor devienne passant en mode basse puissance ou de rétention, et devienne bloqué en mode normal ou actif.

2. Appareil selon la revendication 1, comprenant :
un régulateur (104) de tension couplé à la circuiterie (103) de gestion de puissance, le régulateur de tension étant destiné à fournir une alimentation au premier nœud (106) d'alimentation.

3. Appareil selon la revendication 2 :
la circuiterie (103) de gestion de puissance servant à ordonner au régulateur (106) de tension d'ajuster l'alimentation en fonction d'une sortie de l'amplificateur de lecture associé à la cellule binaire (202) de mémoire, ou
la circuiterie (103) de gestion de puissance servant à ajuster une valeur d'un code d'identification de tension, VID, afin d'ajuster l'alimentation.

4. Appareil selon l'une quelconque des revendications 1 à 3, la circuiterie (103) de gestion de puissance servant à amener une alimentation sur le premier nœud (106) d'alimentation à augmenter progressivement au cours du temps.

5. Appareil selon l'une quelconque des revendications 1 à 3, la cellule binaire (202) de mémoire étant une cellule binaire de mémoire vive statique.

6. Appareil selon l'une quelconque des revendications 1 à 3, le circuit comprenant : soit un empilement de transistors connectés en diode, soit un seul transistor connecté en diode.

7. Appareil selon l'une quelconque des revendications 1 à 3, la circuiterie et le transistor étant partagés par une colonne de cellules binaires de mémoire incluant la cellule binaire (202) de mémoire, et un ou plusieurs amplificateurs de lecture qui incluent l'amplificateur de lecture étant destinés à déterminer un état logique stocké dans la colonne de cellules binaires de mémoire avant et après l'application d'une contrainte de tension et/ou de courant aux cellules binaires afin de fournir une détection précoce d'une défaillance de mémoire pendant le mode d'attente ou de rétention.

8. Appareil selon la revendication 1, comprenant :
un moniteur Vₘᵢₙ de rétention, RVM (101b), couplé à une mémoire, le RVM devant détecter une défaillance de vieillissement de la mémoire, le RVM et la mémoire étant couplés au premier nœud d'alimentation, et le RVM comprenant :
la cellule binaire (202) de mémoire couplée à un deuxième nœud d'alimentation,
la circuiterie couplée aux premier et deuxième nœuds (106, 204) d'alimentation, la circuiterie devant fonctionner dans le mode connecté en diode ; et
le transistor couplé en parallèle à la circuiterie.

9. Appareil selon la revendication 8, comprenant :
une circuiterie (101a) de bit de réplique accordable, TRB, couplé à une mémoire, la circuiterie de TRB servant à détecter une marge de synchronisation pour la mémoire en mesurant une vitesse/synchronisation des cellules de stockage de la matrice de mémoire ;
un circuit (102a) de réplique accordable, TRC, couplé à un bloc logique, le TRC devant détecter une marge de synchronisation et une erreur à l'avance pour le bloc logique en mesurant la vitesse/synchronisation de certaines cellules logiques du bloc logique, le bloc logique et le TRC étant couplés au premier nœud d'alimentation ; et
la circuiterie (103) de gestion de puissance étant couplée de manière à communiquer avec la circuiterie de TRB, le TRC et le RVM.

10. Appareil selon la revendication 9, comprenant un régulateur (104) de tension couplé à la circuiterie (103) de gestion de puissance, la circuiterie (103) de gestion de puissance servant à amener le régulateur (104) de tension à moduler une alimentation fournie au premier nœud (106) d'alimentation en fonction des sorties du TRB, du TRC et du RVM.

11. Appareil selon la revendication 1, comprenant :
un régulateur (104) de tension, le premier nœud (106) d'alimentation étant couplé au régulateur (104) de tension, la circuiterie (103) de gestion de puissance étant couplée au régulateur (104) de tension ;
et
un processeur couplé au premier nœud (106) d'alimentation et à la circuiterie (103) de gestion de puissance, le processeur comprenant une mémoire dotée de la cellule binaire (202) de mémoire, le processeur comprenant :
la circuiterie couplée aux premier et deuxième nœuds d'alimentation, la circuiterie devant fonctionner dans un mode connecté en diode ; et
le transistor couplé en parallèle à la circuiterie, le transistor pouvant être commandé par le signal numérique de sorte que lorsque le transistor doit devenir passant, il doit appliquer une contrainte de tension et/ou de courant à la cellule binaire de mémoire.

12. Appareil selon la revendication 11, comprenant une interface sans fil pour permettre au processeur de communiquer avec un autre dispositif.

13. Système comprenant :
une mémoire ;
un processeur couplé à la mémoire, le processeur comprenant un appareil de réduction de bande de garde de vieillissement, l'appareil étant conforme à l'une quelconque des revendications 1 à 10, la mémoire étant couplée au premier nœud d'alimentation ; et
une interface sans fil pour permettre au processeur de communiquer avec un autre dispositif.
